# EUROPEAN PATENT SPECIFICATION

(11) **EP 2 653 586 B1**
(45) Date of publication and mention of the grant of the patent: **02.03.2016**
(21) Application number: 11848774.3
(22) Date of filing: 25.11.2011
(51) Int. Cl.: C23C 16/503, C23C 16/54, H05H 1/46, H01J 37/32

(54) **PLASMA CVD APPARATUS**
PLASMA-CVD-VORRICHTUNG
APPAREIL DE CVD ASSISTÉ PAR PLASMA

(30) Priority: 16.12.2010 JP 2010280489
(43) Date of publication of application: 23.10.2013
(73) Proprietor: Kabushiki Kaisha Kobe Seiko Sho, Kobe-shi, Hyogo 651-8585 (JP)
(72) Inventor: TAMAGAKI, Hiroshi, Hyogo 676-8670 (JP); OKIMOTO, Tadao, Hyogo 676-8670 (JP)
(74) Representative: TBK
(86) International application number: PCT/JP2011/006570
(87) International publication number: WO 2012/081171

(56) References cited:
- EP-A1- 2 119 811
- EP-A1- 2 487 277
- JP-A- 2003 049 273
- JP-A- 2005 504 880
- JP-A- 2008 196 001
- US-A1- 2004 149 574
- H TAMAGAKI ET AL: "Transparent High Barrier Coating on Polymer Web by PE-CVD Roll Coater", SOCIETY OF VACUUM COATERS 53RD ANNUAL TECHNICAL CONFERENCE PROCEEDINGS, 17 April 2010 (2010-04-17), pages 553-557, XP055183024,

## Description

### TECHNICAL FIELD

The present invention relates to a plasma CVD apparatus that deposits a CVD coating on a substrate such as a plastic film or a plastic sheet.

### BACKGROUND ART

A plastic film used for a display substrate is highly required to have characteristics (barrier properties) that do not allow water vapor or oxygen to pass through or abrasion resistance. In order to make the plastic film or the like to have high barrier properties or high abrasion resistance, a transparent coating made of SiOₓ, Al₂O₃ or the like needs to be coated on a surface of the film. As a conventionally-known coating technique of the SiOₓ coating, there are physical vapor deposition (PVD) methods such as a vacuum deposition method and a sputtering method.

For example, the vacuum deposition method is one of highly-productive methods in the PVD methods, and is extensively used in the field of a film for food packaging. In this vacuum deposition method, high productivity is realized but barrier properties of the deposited coating are not good. Specifically, in one example of numerical value, water vapor transmittance of a coating deposited by the vacuum deposition method is about 1 g/(m²·day), and oxygen transmittance is about 1 cc/(m²·atm·day). These values do not satisfy levels required for the display substrate at all.

Meanwhile, in the PVD methods, the sputtering method is frequently used along with the vacuum deposition method. When a coating is deposited on a substrate having a fine surface state, the coating deposited by the sputtering method can have water vapor transmittance and oxygen transmittance that are equal to or less than detection limits of a MOCON method. Specifically, in the sputtering method, an SiOₓ coating or an SiON coating that is deposited to have a thickness of 50 nm to 100 nm can have water vapor transmittance of 0.2 g/(m²·day) or less and oxygen transmittance of 0.02 cc/ (m²·atm·day) or less. Therefore, barrier properties of the coating deposited by the sputtering method are much more excellent than those of the coating deposited by the vacuum deposition method.

Meanwhile, a deposition rate in the sputtering method is slower than that of the vacuum deposition method, and thus it is difficult to achieve sufficient productivity in the sputtering method.

Further, the coating deposited by the PVD method, that is, both of the coating deposited by the vacuum deposition method and the coating deposited by the sputtering method, has a defect in that the coating is brittle in minerals. For example, when the deposition is performed to have a film thickness of more than 100 nm by the PVD method, the coating does not keep up with internal stress of the coating, a difference between thermal expansion coefficients of the coating and the substrate, and deformation of the film, so that defects or peeling off of the coating may occur. Accordingly, the PVD method is not suitable for the deposition in which the coating of more than 100 nm is deposited on the film substrate.

Unlike the PVD method, a deposition rate in a plasma CVD method is inferior to that in the vacuum deposition but is greater than that in the sputtering method by one digit. In addition, the coating deposited by the plasma CVD method has flexibility of some degree as well as high barrier properties. For this reason, in the plasma CVD method, it is possible to deposit a coating having a thick thickness of several hundreds of nanometers (nm) to several micrometers (µm) which is not obtained in the PVD method, so that the plasma CVD method is expected as a new deposition process utilizing such features.

An example of an apparatus for performing the plasma CVD method is described in Patent Document 1.

The plasma CVD apparatus described in Patent Document 1 includes a vacuum chamber, a delivery roller that is disposed in the vacuum chamber to deliver a film, and a rewinding roller that is disposed in the vacuum chamber to rewind the film. In the plasma CVD apparatus, the deposition is continuously performed on the film delivered from the delivery roller in the vacuum chamber exhausted to vacuum, and then the deposited film is rewound by the rewinding roller. In addition, a pair of deposition rollers around which the film is wound is disposed within the vacuum chamber, and an AC power supply is connected to the pair of deposition rollers. Further, the plasma CVD apparatus of Patent Document 1 is provided with a magnetic field generating section including a plurality of magnets in the deposition rollers. The magnetic field generating section generates a magnetic field in a tangent direction to surfaces of the deposition rollers. Meanwhile, when the AC power supply applies an AC voltage to the pair of deposition rollers, an electric field is generated in a normal direction to outer peripheries of the deposition rollers.

That is, the plasma CVD apparatus of Patent Document 1 generates locally magnetron discharge in a region where the magnetic field generated in the tangent direction between the pair of deposition rollers interacts with the electric field generated in the normal direction each other, and deposits a CVD coating using plasma ionized by the magnetron discharge.

In the plasma CVD apparatus of Patent Document 1, however, a region where plasma is generated is limited to a part of a space between the pair of deposition rollers (counter space). When the film is taken out of this space, the deposition is not performed on the film. That is, in the plasma CVD apparatus of Patent Document 1, since the region where plasma is generated, namely, the deposition area, is limited to the part of the space between the pair of deposition rollers, there is no concern that flakes are generated due to the deposition of unnecessary coating. However, when the deposition is performed in only the limited deposition area, a deposition rate is not increased, so that the productivity of the deposition is degraded.

### A further plasma CVD device is disclosed in post-published Patent Document 2.

### CITATION LIST

### PATENT DOCUMENT

Patent Document 1: JP 2008-196001 A
Patent Document 2: EP 2 487 277 A1

### SUMMARY OF THE INVENTION

An object of the present invention is to provide a plasma CVD apparatus capable of realizing high productivity.

According to the present invention, the above object is solved with a plasma CVD apparatus having the features of claim 1.

### BRIEF DESCRIPTION OF DRAWINGS

[Fig. 1] Fig. 1 is a front view of a plasma CVD apparatus according to a first embodiment of the present invention.
[Fig. 2] Fig. 2 is an enlarged view of a deposition part in the plasma CVD apparatus.
[Fig. 3] Fig. 3 is a diagram illustrating waveforms of an alternating current that is applied to a deposition roller from a plasma power supply in the plasma CVD apparatus.
[Fig. 4] Fig. 4 is an enlarged perspective view of a magnetic field generating section of the plasma CVD apparatus.
[Fig. 5] Fig. 5 is a diagram illustrating a deposition section of a plasma CVD apparatus according to a second embodiment.
[Fig.6] Fig. 6 is a diagram illustrating a deposition section of a plasma CVD apparatus according to a third embodiment.
[Fig. 7] Fig. 7 is a diagram illustrating a modified example of the deposition portion of the plasma CVD apparatus according to the third embodiment.
[Fig. 8] Fig. 8 is a diagram illustrating a deposition section of a plasma CVD apparatus according to a fourth embodiment.

### DESCRIPTION OF EMBODIMENTS

Hereinafter, embodiments, including embodiments of the present invention, will be described with reference to the drawings.

### [First Embodiment]

Hereinafter, a plasma CVD apparatus according to a first embodiment of the present invention will now be described with reference to the drawings.

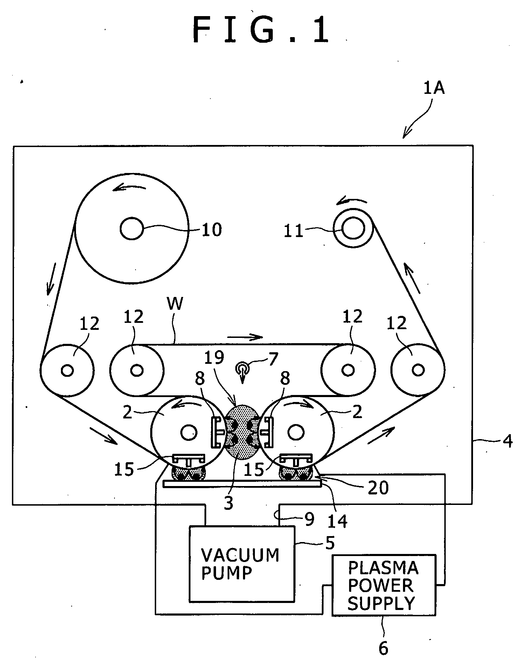

Fig. 1 illustrates an entire configuration of a plasma CVD apparatus 1A according to the first embodiment of the present invention.

In the plasma CVD apparatus 1A of the present embodiment, an AC voltage or a pulse voltage accompanied by polarity reversal is applied to a pair of deposition rollers 2 and 2 disposed so as to face each other with a predetermined space (counter space) 3 formed therebetween under reduced pressure, and thus glow discharge occurs in the space 3 sandwiched between the pair of deposition rollers 2 and 2. In the plasma CVD apparatus 1A, furthermore, the deposition is performed on a substrate W by plasma CVD using plasma of a process gas ionized through the glow discharge. The plasma CVD apparatus 1A is provided with a pair of deposition rollers 2 and 2, a vacuum chamber 4, a vacuum pump system 5, a plasma power supply 6, and magnetic field generating sections 8 and 15.

The vacuum chamber 4 is a housing shape of which an internal part is hollow. The vacuum pump system 5, for example, includes a vacuum pump and is connected to the vacuum chamber 4 to evacuate the internal part of the vacuum chamber.

The pair of deposition rollers (first deposition roller and second deposition roller) 2 and 2 is disposed in such a manner that axis centers face toward a horizontal direction (direction penetrating paper plane in Fig. 1) and are parallel to each other side by side with a distance in a horizontal direction which is perpendicular thereto. Both poles of the plasma power supply 6 (AC power supply) are connected to each of the deposition rollers 2, respectively. In addition, a sheet-shaped substrate W to be deposited may be wound around these pair deposition rollers 2 and 2. Moreover, the vacuum chamber 4 is provided with a gas supplying section 7 that supplies a process gas to the inside of the vacuum chamber 4. In the internal part of each deposition roller 2, the magnetic field generating sections (first magnetic field generating section 8 and second magnetic field generating section 15) are installed to generate plasma.

Hereinafter, the plasma CVD apparatus 1A is described in detail. With respect to this description, however, top and bottom in the paper plane of Fig. 1 indicate top and bottom of the plasma CVD apparatus 1A. In addition, right and left of Fig. 1 indicate right and left of the plasma CVD apparatus 1A.

In the vacuum chamber 4, since the internal hollow thereof is surrounded by upper and lower partitions, right and left partitions, and back and forth partitions, the inside can be hermetically maintained with respect to the outside. The vacuum pump system 5 is connected to an exhaust port 9 formed at a lower partition of the vacuum chamber 4, and thereby the inside of the vacuum chamber 4 can be exhausted to a vacuum state or a low pressure state equivalent to the vacuum state in response to a command from the outside. The process gas is supplied from the gas supplying section 7 to the inside of the vacuum chamber 4 which has become the vacuum (low pressure) state by a vacuum pump 5. At this time, the inside of the vacuum chamber 4 becomes a proper pressure through the balance between the exhaust from the vacuum pump 5 and the air supply from the gas supplying section 7.

Each deposition roller 2 has a cylindrical body made of stainless steel or the like, with the same diameter and the same length. Each deposition roller 2 is installed such that each rotation center is located at the substantially same height from a bottom surface (upper surface of lower partition) of the vacuum chamber 4. Both deposition rollers 2 and 2 are disposed such that axis centers are parallel to each other side by side with a distance in the horizontal direction, and thereby outer peripheries of both deposition rollers 2 and 2 face each other with the space 3 sandwiched therebetween.

Each deposition roller 2 has a dimension in the center of axis longer than the largest width of the substrate W having the largest width so as to allow the substrates W of various dimensional widths to be wound therearound. Each deposition roller 2 can circulate a medium such as temperature-regulated water in the inside thereof, and thereby it is possible to regulate the temperature of the roller surface. In order to prevent the surface of each deposition roller 2 from being scratched, chrome plating or coating of cemented carbide or the like is preferably performed.

Both deposition rollers 2 and 2 are electrically insulated from the vacuum chamber 4 and electrically insulated from each other. One pole of the plasma power supply 6 is connected to one of the pair of deposition rollers 2 and 2, and the other pole of the plasma power supply 6 is connected to the other of the pair of deposition rollers 2 and 2. That is, each deposition roller 2 is provided by potentials having polarities different from each other, and the plasma power supply 6 is connected to the both deposition rollers 2 and 2 so that the potentials of different polarities are reversed by AC frequency. Since the substrate W to be deposited is composed of non-conductive materials (insulating materials) which will be described later, even when DC voltage is applied between the deposition rollers 2 and 2, current cannot flow through the substrate. However, current can flow by applying voltage having appropriate frequency (about 1 kHz or more, preferably, 10 kHz or more) to the pair of deposition rollers 2 and 2 depending on the thickness of the substrate W. Moreover, glow discharge can be generated between both deposition rollers 2 and 2 by applying AC voltage within a range from hundreds of V to 2,000 V between the pair of deposition rollers 2 and 2. In addition, there is no particular upper limit of the frequency, when the frequency is 10 MHz or more, steady wave is generated. Accordingly, it is preferable that the frequency is 10 MHz or less.

In addition, as the substrate W (for deposition of CVD coating) to be rewound around the pair of the deposition rollers 2 and 2, insulating materials such as a plastic film or sheet, paper, and the like are used. The insulating materials can be rewound in the form of roll. The substrate W is rewound on a delivery roller 10 disposed in the vacuum chamber 4. The plastic film or sheet to be used as the substrate W includes, for example, PET, PEN, PES, polycarbonate, polyolefin, or polyimide. The thickness of the substrate W is preferably 5 µm to 0.5 mm which can carry in the vacuum. The substrate W is rewound in the form of roll by a rewinding roller 11 within the vacuum chamber 4 after the CVD coating is deposited.

The above-described delivery roller 10 is disposed on the upper left side of the left deposition roller 2 in the inside of the vacuum chamber 4. Furthermore, the rewinding roller 11 is disposed on the upper right side of the right deposition roller 2 in the inside of the vacuum chamber 4. The pair of deposition rollers 2 and 2 and a plurality of guide rollers 12 are disposed between the delivery roller 10 and the rewinding roller 11.

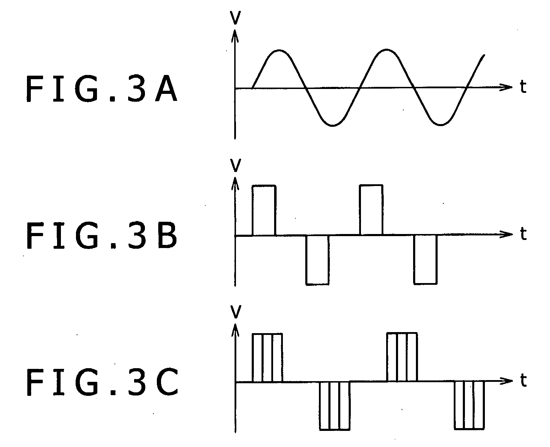

The plasma power supply 6 can apply AC voltage of sinusoidal curve as illustrated in Fig 3A or pulse-formed voltage of which polarities of both poles reverse with the lapse of time as illustrated in Fig. 3(b).

The both poles of this plasma power supply 6 have a floating potential insulated from the vacuum chamber 4 and are each connected to both deposition rollers 2 and 2, thereby applying the potential which can generate the discharge between the deposition rollers 2 and 2 to each deposition roller 2. Moreover, pulse-shaped voltage supplied from the plasma power supply 6 may be voltage of which following operations are repeated. As illustrated in Fig. 3(c), after short pulses of the same polarity are continuously transmitted by constant number of times, the polarity is changed, and thereby short pulses are transmitted by the same number of times.

In addition, the plasma CVD apparatus 1A is provided with a gas supplying section 7 that supplies process gas into the vacuum chamber 4 and a gas exhaust section that exhausts the process gas from the vacuum chamber 4. The gas supplying section 7 supplies the process gas onto the upper side of the space 3 sandwiched between the pair of deposition rollers 2 and 2. Further, the gas exhaust section exhausts the process gas to the outside of the vacuum chamber 4 from the downside (lower position) of each deposition roller 2.

The gas supplying section 7 is disposed at the upper right side viewed from the left deposition roller 2 and at the upper left side viewed from the right deposition roller 2 in the vacuum chamber 4. This gas supplying section 7 is a tubular member and is mounted within the vacuum chamber 4 so as to be parallel to the center of axis of each deposition roller 2. The inside of the gas supplying section 7 is hollow. Process gas, which will be described hereinafter, is circulated at this inside and the process gas is guided to the inside from the outside of the vacuum chamber 4. A plurality of fine pores 13 in communication with the inside and outside of the gas supplying section 7 are installed along longitudinal direction (direction in axis center of deposition roller 2) thereof at a lower part of the gas supplying section 7 so as to emit the process gas, which flows into the inside of the gas supplying section 7, to the lower part. The process gas emitted from each fine pore 13 is supplied to the space 3 sandwiched between the pair of deposition rollers 2 and 2.

The gas exhaust section exhausts the process gas within the vacuum chamber 4 to the outside from the exhaust port 9 which opens on the lower partition of the vacuum chamber 4. According to the present embodiment, the vacuum pump (vacuum pump system) 5 connected to the exhaust port 9 also serves as the gas exhaust section. In addition, the gas exhaust section and the vacuum pump system 5 may not be a common apparatus. For example, the gas exhaust section and the vacuum pump system 5 may be individually installed in the vacuum chamber 4, respectively. In this case, the vacuum pump system 5 exhausts the inside of the vacuum chamber 4 to become a vacuum state or a low pressure state equivalent to the vacuum state. Then, the pressure within the vacuum chamber 4 is controlled by supplying the process gas to the inside of the vacuum chamber 4 from the gas supplying section 7 and exhausting the process gas from the vacuum chamber 4 through the gas exhaust section.

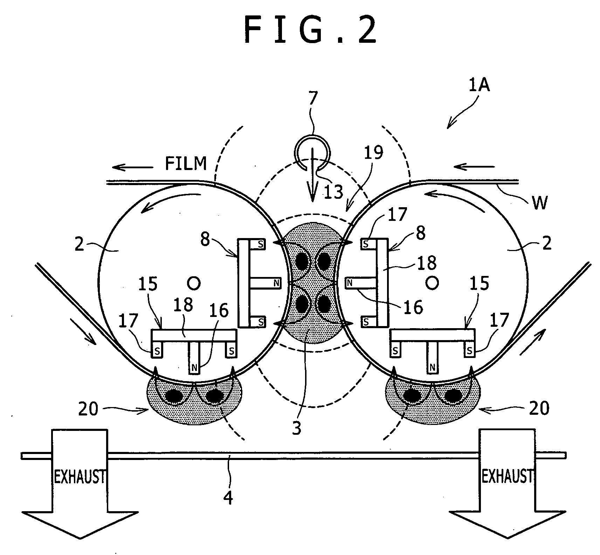

In the plasma CVD apparatus 1A of Fig. 1, for example, only one exhaust port 9 is installed at the lower position of the space 3 in the lower partition of the vacuum chamber 4 and the vacuum pump 5 is connected to this exhaust port 9. Further, a gas manifold 14 is installed between the exhaust port 9 and the space 3. The gas manifold 14 has a plate shape which spreads throughout a horizontal direction and separates the process gas flowing toward the lower part from the space 3 into right and left. That is, the process gas supplied inside the vacuum chamber 4 by the gas supplying section 7 and flowing down by passing through the space 3 collides with the gas manifold 14 spreading in the direction perpendicular to the flow (briefly, orthogonal), and thereby the flow of the process gas is separated into one deposition roller 2 and the other deposition roller 2 along such gas manifold 14. For this reason, the process gas passing through the space 3 is guided to a region adjacent to a lower periphery of the left deposition roller 2 and a region adjacent to a lower periphery of the right deposition roller 2. This gas manifold 14 also prevents foreign materials such as a coating flake being mixed into the vacuum pump 5. In addition, Fig. 1 illustrates that the gas manifold 14 separates the process gas flowing down from the space 3, but is not limited thereto. For example, the exhaust ports 9 are installed at the lower position of each deposition roller 2, respectively, in the lower partition of the vacuum chamber 4 and the vacuum pump 5 may be connected to each exhaust port 9. According to such configuration, it can separate the process gas without using the gas manifold 14. Accordingly, in Fig. 2 to Fig. 8, the exhausts of process gas from the exhaust port 9 at the lower position of each deposition roller 2 are indicated by arrows and the detailed representation thereof will not be repeated.

As the process gas to be supplied from the gas supplying section 7, for example, process gas, reaction gas, and auxiliary gas are used in combination. Such process gas is supplied into the vacuum chamber 4 from the gas supplying section 7 as described above. The process gas is a component which supplies the material serving as a main component of the coating. For example, when SiOₓ coating is deposited within the vacuum chamber 4, examples of the process gas include such as HMDSO (hexamethyldisiloxane), TEOS (tetraethoxysikane), silane which contain Si serving as a main component of the SiOₓ coating. The reaction gas is a component not depositing the coating itself but reacting with the process gas to be introduced into the SiOₓ coating. For example, when the SiOₓ coating is deposited in the vacuum chamber 4, oxygen (O₂) is selected to deposit the SiOₓ coating by reacting with Si, as the reaction gas. The auxiliary gas is composed of components regardless with the composition of the coating in principle, but is supplied for purposes of improvement in discharge stability, coating quality improvement, or the flow assistance of the process gas. For example, when the SiOₓ coating is deposited in the vacuum chamber 4, Ar, He or the like is used as the auxiliary gas.

As illustrated in Fig. 2, the plasma CVD apparatus 1A includes a magnetic field generating section that generates plasma in a desired region.

The magnetic field generating section includes a first magnetic field generating section 8 and a second magnetic field generating section 15 and these first and second magnetic field generating sections 8 and 15 are installed at different positions within the vacuum chamber 4, respectively.

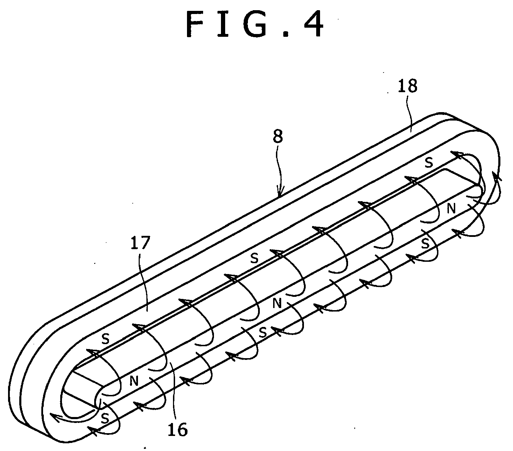

As illustrated in Fig. 2, the first magnetic field generating section 8 is within the each deposition roller 2 and is disposed so as to face toward the space 3 sandwiched between the pair of deposition rollers 2 and 2. That is, the first magnetic field generating section 8 is disposed along a portion adjacent to the space 3 even in the center of periphery wall of each deposition roller 2 so as to generate magnetic field at the space 3 between the pair of deposition rollers 2 and 2. In an example of drawing, the first magnetic field generating section 8, in a case of the left deposition roller 2, is disposed at the position between two o'clock and four o'clock of clock board along an inner periphery. Further, the first magnetic field generating section 8, in a case of the right deposition roller 2, is disposed at the position between eight o'clock and ten o'clock of clock board along an inner periphery. The first magnetic field generating section 8, for example, has the same configuration as a magnetic field generating section to be used in so-called a planar magnetron sputtering cathode as illustrated in Fig. 4.

More specifically, as illustrated in Fig. 4, the first magnetic field generating section 8 is disposed inside each deposition roller 2 and includes a magnet for generating magnetic field on the surface of such deposition roller 2. By the generated magnetic field, the first magnetic field generating section 8 has a function which confines the plasma on the surface (specifically, region adjacent to the surface) of such deposition roller 2. Specifically, the first magnetic field generating section 8 includes a bar-shaped central magnet 16 extending in the direction (direction of roller width) parallel to the axis center of each deposition roller 2 and a circumferential magnet 17 that has a shape surrounding the central magnet, viewed from a direction (radial direction of deposition roller 2) perpendicular to the longitudinal direction thereof. The central magnet 16 is installed at a middle position of a width direction (vertical direction in Fig. 4) perpendicular to the longitudinal direction in the first magnetic field generating section 8 such that the axis center of the central magnet 16 is parallel to that of the deposition roller 2. The circumferential magnet 17 has, for example, a race track shape. That is, the race track-shaped circumferential magnet 17 has a shape including integrally a straight line part that is located at both sides of the width direction with respect to the central magnet 16 and is parallel to the central magnet 16 and a semi-circular part that links between both ends of the straight line part. Moreover, the race track-shaped circumferential magnet 17 is disposed so as to surround the central magnet 16 with the distance from the central magnet 16 on the surface (on the vertical surface in an example illustrated in Fig. 4) passing through the axis center of the central magnet 16.

In the central magnet 16, magnetic poles are installed to face toward the direction (radial direction of the deposition roller 2) perpendicular to the axis center thereof and are installed such that N-pole is directed to the outside of the radial direction, in an example of drawings. In the circumferential magnet 17, magnetic poles are installed to face toward the direction against the magnetic poles of the central magnet 16 and are installed such that S-pole is directed to the outside of the radial direction, in an example of drawings. That is, in the first magnetic field generating section 8, both N-pole of the central magnet 16 and S-pole of the circumferential magnet 17 are directed to the outside of the radial direction and both magnets 16 and 17 are disposed in the first magnetic field generating section 8 so as to generate the magnetic field represented by curved magnetic lines. The magnetic lines are curved as follows: go toward the outside of the deposition roller 2 from N-pole of the circumferential magnet 17 which is within each deposition roller 2, bend in the form of circular arc, and go again back to S-pole of the circumferential magnet 17 installed in the deposition roller 2.

With respect to these central magnet 16 and circumferential magnet 17, each other's relative position is fixed using a fixed member 18. That is, the central magnet 16 and the circumferential magnet 17 are connected to each other by the fixed member 18. The fixed member 18 is formed by a magnetic substance and serves as a magnetic circuit which helps in the generation of magnetic field. In addition, the fixed member 18 is configured so as not to change a generating direction of magnetic field which is generated by the central magnet 16 and the circumferential magnet 17 connected to each other by such fixed member 18, even when the deposition roller 2 is rotated.

In the state where these first magnetic field generating sections 8 are incorporated in each deposition roller 2 and the process gas is supplied into the vacuum chamber 4 from the gas supplying section 7, when AC voltage is applied to both deposition rollers 2 and 2, a race track-shaped homogeneous magnetron plasma in the axis center direction of such deposition roller 2 is generated in the vicinity of the roller surface adjacent to the first magnetic field generating section 8 in the deposition roller 2 on the side to which negative voltage is applied. Since the applied voltage is alternate current, the polarity is reversed with the lapse of time and negative voltage is applied to the opposite deposition roller 2 by then, thereby the magnetron plasma is similarly generated. At this time, since AC voltage to be applied to both deposition rollers 2 and 2 is high-frequency wave of 1 kHz or more in frequency, the plasma seems to be always generated in both deposition rollers 2 and 2 by appearances. Thus, with respect to the deposition region formed in the space 3 between the pair of deposition rollers 2 and 2, hereinafter, it is referred to as a first deposition area 19.

To improve deposition rate in the plasma CVD apparatus, with only such first deposition area 19, it does not obtain a dimension of a sufficient deposition area. For this reason, a deposition region (second deposition area 20) different from the first deposition area 19 is installed in the plasma CVD apparatus 1A of the present embodiment, and thereby sufficient deposition rate is ensured by performing the deposition even in the second deposition area 20.

The second deposition area 20 is a deposition region installed separately from the first deposition area 19 within the space 3 between the pair of deposition rollers 2, 2 in this embodiment, is formed along the portion lower than the space 3 in the surface of each deposition roller 2. Specifically, the second deposition area 20 is formed by the second magnetic field generating section 15.

The second magnetic field generating section 15 is installed at the position different from the first magnetic field generating section 8. The configuration of the second magnetic field generating section 15 is approximately similar to that of the first magnetic field generating section 8. That is, the second magnetic field generating section 15 has, for example, the configuration similar to that of the magnetic field generating section to be used in the planar magnetron sputtering cathode as illustrated in Fig. 4. Accordingly, the detailed description of the second magnetic field generating section 15 will not be made.

As illustrated in Fig. 2, the second magnetic field generating section 15 of the present embodiment is disposed within each deposition roller 2 and along a lower portion of the peripheral wall of such deposition roller 2. The position between the lower portion of the peripheral wall of the deposition roller 2 and the second magnetic field generating section 15 is adjacent to each other. In an example of drawings, for example, the second magnetic field generating section 15 is disposed at the position between five o'clock and seven o'clock of the clock board.

In the state where these second magnetic field generating sections 15 are incorporated in each deposition roller 2 and the process gas is supplied into the vacuum chamber 4 from the gas supplying section 7, when AC voltage is applied to both deposition rollers 2 and 2, a race track-shaped homogeneous magnetron plasma in the axis center direction of such deposition roller 2 is generated in the vicinity, that is, the lower side of the deposition roller 2, of the roller surface adjacent to the second magnetic field generating section 15 in the deposition roller 2 on the side to which negative voltage is applied. Since the applied voltage is alternate current, the polarity is reversed with the lapse of time and negative voltage is applied to the opposite deposition roller 2 by then, thereby the magnetron plasma is similarly generated. At this time, like those above, since AC voltage to be applied to both deposition rollers 2 and 2 is high-frequency wave of 1 kHz or more in frequency, the plasma seems to be always generated in both deposition rollers 2 and 2 by appearances.

As described above, in the present embodiment, the first deposition area 19 is formed within the space 3 between the pair of deposition rollers 2 and 2 by the first and second magnetic field generating sections 8 and 15 and the second deposition area 20 is formed at the region apart downward from the lower outer-periphery of each deposition roller 2 by a desired distance, thereby the deposition is carried out in these two deposition areas 19 and 20, respectively.

At this time, since the magnetic pole of the outer portion in the radial direction of the deposition roller 2 of the end (straight line part) of the second magnetic field generating section 15 in the circumferential magnet 17 of the first magnetic field generating section 8 is the same polarity as that of the outer portion in the radial direction of the end (straight line part) of the first magnetic field generating section 8 in the circumferential magnet 17 of the second magnetic field generating section 15, it can prevent the plasma from being non-homogeneous in the intermediate part between the first magnetic field generating section 8 and the second magnetic field generating section 15, thereby the coating deposition becomes stable.

Next, it will be described with respect to procedures when the deposition is performed on the substrate W using the plasma CVD apparatus 1A of the above first embodiment.

The roll-shaped rewound substrate W is attached to the delivery roller 10 within the vacuum chamber 4. In addition, the substrate W sent from the delivery roller 10 is guided to the rewinding roller 11 via the pair of deposition rollers 2 and 2 and the plurality of guide rollers 12.

Next, the inside of the vacuum chamber 4 can become a vacuum state or a low pressure state equivalent to the vacuum state by the exhaust operation of the vacuum pump 5. Further, the process gas is supplied to the inside of the vacuum chamber 4 from the gas supplying section 7 disposed on the upper side of the space 3 between the pair of deposition rollers 2 and 2. At this time, the inside of the vacuum chamber 4 is made to become a proper pressure through the balance between the exhaust from the vacuum pump (gas exhaust section) 5 and the air supply from the gas supplying section 7.

Then, the process gas is emitted toward the space 3 from the fine pore 13 formed in the lower part of the gas supplying section 7 and the space 3 is filled with the process gas. In this condition, when the plasma power supply 6 applies AC voltage between the pair of deposition rollers 2 and 2 provided with the first magnetic field generating section 8 and the second magnetic field generating section 15, respectively, the magnetron discharge is generated by the first magnetic field generating section 8 in the desired region (first deposition area 19) along the roller surface within the space 3 between the pair of deposition rollers 2 and 2 and the desired region (second deposition area 20) along the lower roller surface of the deposition roller 2, respectively.

Accordingly, the process gas supplied from the gas supplying section 7 is ionized in two places of the first deposition area 19 and the second deposition area 20 to become the plasma, and thereby the deposition is performed over a plurality of times in both regions of the first deposition area 19 and the second deposition area 20 and the deposition rate is improved by the increase of the number of depositions.

### [Second Embodiment]

Next, a plasma CVD apparatus will be described according to a second embodiment.

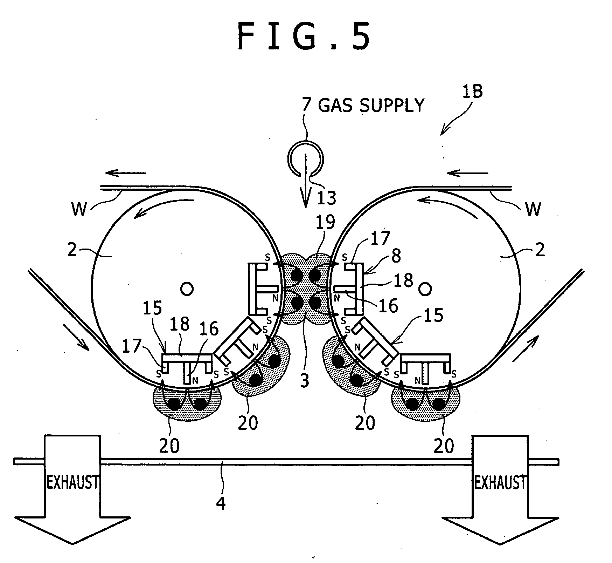

As illustrated in Fig. 5, in the plasma CVD apparatus 1B of the second embodiment, a second magnetic field generating section 15 is disposed inside a deposition roller 2 as a member different from the first magnetic field generating section 8 like the first embodiment, but a plurality of second magnetic field generating sections 15 (two second magnetic field generating sections in the present embodiment) are arranged in a circumferential direction of a corresponding deposition roller 2 in the inside of each deposition roller 2, unlike the plasma CVD apparatus 1A of the first embodiment.

That is, the second magnetic field generating sections 15 are disposed at, for example, two places of a position between four o'clock and five o'clock and a position between five o'clock and seven o'clock of the clock board in a case of the left deposition roller 2. Further, the second magnetic field generating sections 15 are disposed at, for example, two places of a position between seven o'clock and eight o'clock and a position between eight o'clock and ten o'clock of the clock board in a case of the right deposition roller 2.

Like this, since the plurality of second magnetic field generating sections 15 are arranged along the circumferential direction of the corresponding deposition roller 2 in each deposition roller 2, the range of the second deposition area 20 in the direction along the surface of the deposition roller 2 is widened as the number of the second magnetic field generating sections 15 increase, thereby the deposition rate is improved by the widened amount of this deposition area.

### [Third Embodiment]

Next, a plasma CVD apparatus will be described according to a third embodiment.

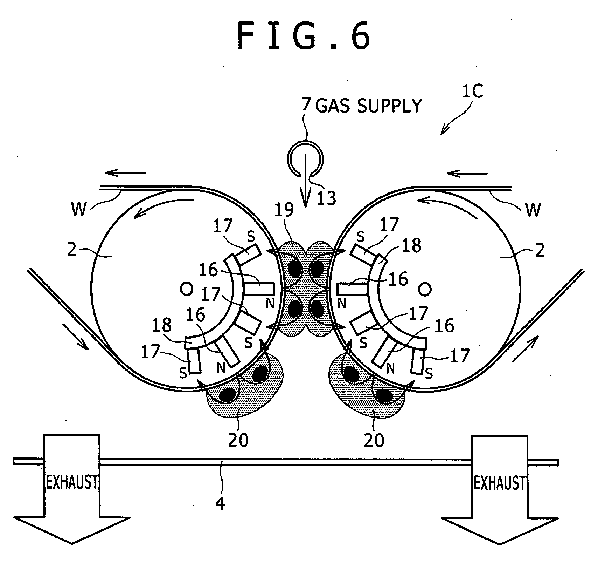

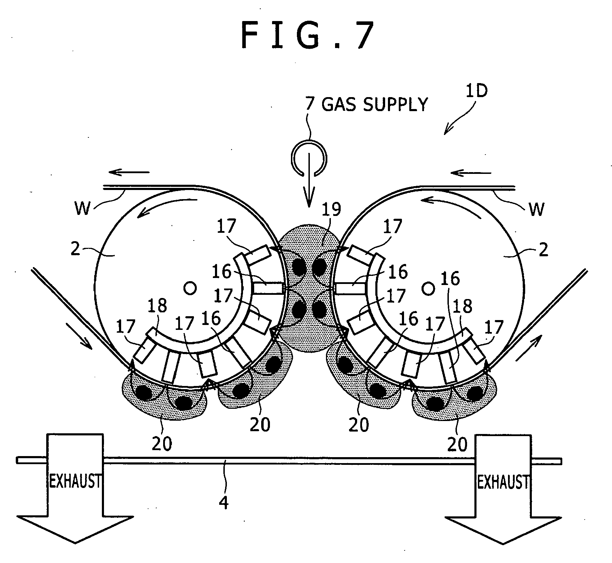

As illustrated in Figs. 6 and 7, the plasma CVD apparatuses 1C and 1D of the third embodiment are the same as the plasma CVD apparatus 1A of the first embodiment and the plasma CVD apparatus 1B of the second embodiment in that a first magnetic field generating section 8 and a second magnetic field generating section 15 are provided, but is different from the plasma CVD apparatus 1A of the first embodiment and the plasma CVD apparatus 1B of the second embodiment in that the first magnetic field generating section 8 and the second magnetic field generating section 15 are integrally constructed. Specifically, the first and second magnetic field generating sections 8 and 15 configured by the central magnet 16 and the race track-shaped circumferential magnet 17 are juxtaposed along the circumferential direction of deposition rollers 2A and B. At this time, a portion of the circumferential magnet 17 of the magnetic field generating sections 8 and 15 adjacent to each other is used in common. Accordingly, the magnetic field is generated in both of the region where the first deposition area 19 is formed and the region where the second deposition area 20 is formed, by one magnetic field generating section (which integrally connects the first and second magnetic field generating sections to each other). In other words, the first magnetic field generating section 8 and the second magnetic field generating section 15 are formed as one member that is continuous in the circumferential direction of each deposition roller 2 in the plasma CVD apparatus 1C of the third embodiment.

In an example of Fig. 6, for example, the central magnets 16 are disposed at three o'clock position and five o'clock position of the clock board around the axis center of the deposition roller 2, respectively, and the race track-shaped circumferential magnets 17 are disposed around each central magnet 16, respectively, when the magnetic field generating section is installed in the left deposition roller 2. At this time, the magnet (straight line part of circumferential magnet 17) of four o'clock position of the clock board is used in common in the circumferential magnet 17 surrounding each central magnet 16. Accordingly, the first and second magnetic field generating sections 8 and 15 are effectively disposed inside the narrow deposition roller 2 and the magnetic field is generated in a wide range (120° range) in the circumferential direction in the vicinity of the surface of the deposition roller 2.

Furthermore, in an example of Fig. 7, three central magnets 16 are disposed at three o'clock position, five o'clock position, and seven o'clock position of the clock board around the axis center of the deposition roller 2, and the race track-shaped circumferential magnets 17 are disposed around each central magnet 16, respectively, when the magnetic field generating section is installed in the left deposition roller 2. At this time, in the circumferential magnet 17 surrounding each central magnet 16, the magnet (straight line part of circumferential magnet 17) of four o'clock position and six o'clock position of the clock board is used in common in the adjacent two race track-shaped circumferential magnets 17. Accordingly, the first magnetic field generating section 8 and two second magnetic field generating sections 15 and 15 are effectively disposed inside the narrow deposition roller 2 and the magnetic field is generated in a wide range (160° range) in the circumferential direction in the vicinity the surface of each deposition roller 2.

When these magnetic field generating sections are used, the portion corresponding to the space 3 in the magnetic field generating section generates the plasma in the first deposition area 19 and other portions excluding the portion corresponding to the space 3 generate the plasma in the second deposition area 20. For this reason, the deposition rate is further improved.

### [Fourth Embodiment]

A plasma CVD apparatus will now be described according to a fourth embodiment.

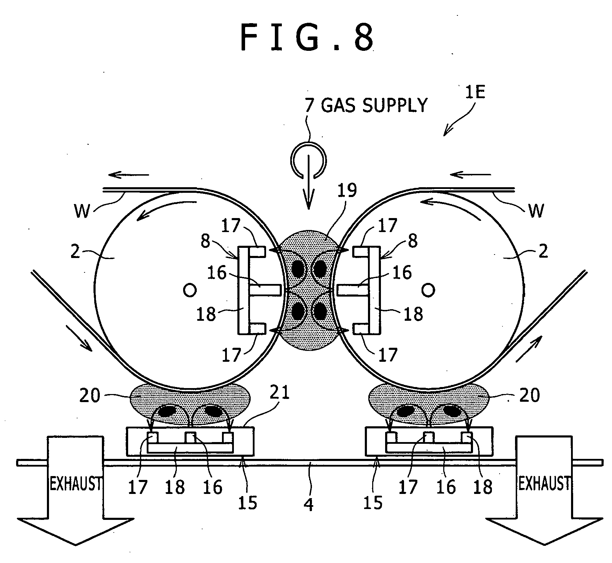

As illustrated in Fig. 8, the plasma CVD apparatus 1E of the fourth embodiment is the same as the plasma CVD apparatuses 1A, 1B, 1C, and 1D of the first to third embodiments in that the first magnetic field generating section 8 is installed inside the deposition roller 2 to generate the plasma in the first deposition area 19. On the contrary, the plasma CVD apparatus 1E of the fourth embodiment is characterized by following reasons. Meanwhile, the plasma CVD apparatus 1E of the fourth embodiment is different from the plasma CVD apparatuses 1A, 1B, 1C, and 1D of the first to third embodiments in that the second magnetic field generating section 15 is outside each deposition roller 2 and is installed below both deposition rollers 2 and 2 to generate the plasma in the second deposition area 20.

Specifically, in the plasma CVD apparatus 1E of the fourth embodiment, the second magnetic field generating section 15 has the same configuration as that of the first embodiment, and is outside each of the deposition rollers 2 and 2 to be disposed below the deposition rollers 2 and 2. Between the second magnetic field generating section 15 and the lowest portion in the outer periphery of the deposition roller 2, the interval sufficient to generate the plasma in vertical direction is formed. This interval is approximately equal to an interval in the horizontal direction between the pair of deposition rollers 2 and 2 in the first deposition area 19 and is sufficient to generate the plasma. Even though the second magnetic field generating section 15 is disposed outside the deposition roller 2, the magnetic field is generated in the region where the second deposition area 20 is formed along the lower surface of the deposition roller 2.

Furthermore, the second magnetic field generating section 15 disposed outside the deposition roller 2 according to the fourth embodiment, as illustrated in Fig. 8, may be covered by a housing-shaped case 21. In this case, unlike the first embodiment, the central magnet 16 and the race track-shaped circumferential magnet 17 may have the same height in the vertical direction.

In addition, the pair of deposition rollers 2 and 2 has preferably the same diameter and the same length in the axis center direction, but may not necessarily have the same diameter and the same length in the axis center direction. Moreover, the pair deposition rollers 2 and 2 are preferably disposed such that each axis center is located on a common horizontal surface, but each axis center may not necessarily be located on a common horizontal surface.

### [SUMMARY OF EMBODIMENTS]

The above embodiments are summarized as follows.

The plasma CVD apparatus of the present invention includes a vacuum chamber, a pair of deposition rollers that is disposed in the vacuum chamber and which winds around a substrate to be deposited, a magnetic field generating section that generates a magnetic field causing plasma on surfaces of the deposition rollers to form a deposition area where a coating is deposited on the substrate wound around the deposition rollers. Moreover, the pair of deposition rollers includes a first deposition roller and a second deposition roller that is apart from the first deposition roller with an interval such that an axis center thereof is parallel to that of the first deposition roller. The magnetic field generating section is disposed such that a first deposition area is formed in a space between the pair of deposition rollers and a second deposition area is formed in a region adjacent to the surfaces of the deposition rollers and other than the space between the deposition rollers, as the deposition area.

According to such configuration, the deposition is performed on the substrate in the deposition area (first deposition area) to be formed the space between the pair of deposition rollers and even in the second deposition area which is within the space other than the space between the pair of deposition rollers and is formed in the region adjacent to the surface of the deposition roller, thereby the deposition rate is improved. That is, since the magnetic field generating section is disposed so as to form the first deposition area in the space between the pair of deposition rollers and the second deposition area which is within the space other than the space between the pair of deposition rollers and adjacent to the surface of the deposition roller, the deposition area is widened compared to the apparatus for performing the deposition in only the first deposition area.

In addition, it is preferable that the pair of deposition rollers is disposed such that the axis centers are directed to the horizontal direction, respectively, and the axis centers are parallel to each other at intervals in the horizontal direction. Further, it is preferable that the second deposition area is formed along a portion lower than the space between the deposition rollers in the surface of the deposition roller.

In a case of such arrangement, it is preferable that the plasma CVD apparatus includes the gas supplying section that supplies process gas for deposition into the vacuum chamber and the gas exhaust section that exhausts the process gas from the vacuum chamber, the gas supplying section supplies the process gas into the vacuum chamber from the upper part of the space between the deposition rollers, and the gas exhaust section exhausts the process gas to the outside of the vacuum chamber from the lower side of the deposition roller.

According to the above configuration, since the process gas flows toward the gas exhaust section from the gas supplying section in the vacuum chamber, the process gas is surely introduced to the second deposition area from the first deposition area by only supplying the process gas from the upper part of the space between the deposition rollers through the gas supplying section. For this reason, the plasma can surely be generated in both areas.

Further, in the plasma CVD apparatus, the magnetic field generating section includes the first magnetic field generating section that generates the plasma in the first deposition area and the second magnetic field generating section that generates the plasma in the second deposition area, and the first magnetic field generating section and second magnetic field generating section may be installed in the deposition roller, respectively.

According to such configuration, the entire compact apparatus may be implemented by installing the first magnetic field generating section and the second magnetic field generating section in the deposition roller. Further, it may easily create the deposition area in the vicinity (region adjacent to the surface) of the surface of the deposition roller.

In addition, the magnetic field generating section includes the first magnetic field generating section that generates the plasma in the first deposition area and the second magnetic field generating section that generates the plasma in the second deposition area, the first magnetic field generating section is installed in the deposition roller, and the second magnetic field generating section may be installed at outside of the deposition roller and at the lower side of the deposition roller.

According to such configuration, as the second magnetic field generating section, the plate magnetic field generating section (so called, the magnetic field generating section and the like used for a planar machine magnetron sputtering cathode) that is usually used may be used.

In the plasma CVD apparatus, when the first and second magnetic field generating sections are concurrently disposed inside the deposition roller, the first and second magnetic field generating sections each include the plurality of magnets for generating the magnetic field that confines the plasma and are disposed at intervals in the circumferential direction of the deposition roller, and the magnetic pole of the outer portion in the radial direction of the deposition roller in the magnet of the second magnetic field generating section-side end of the first magnetic field generating section may be the same polarity as that of the outer portion in the radial direction of the deposition roller in the magnet of the first magnetic field generating section-side end of the second magnetic field generating section.

According to such configuration, it can prevent the plasma from being non-homogeneous in the intermediate portion between the first magnetic field generating section and the second magnetic field generating section, the coating deposition thereby becomes stable.

In addition, when the first and second magnetic field generating sections are concurrently disposed inside the deposition roller, the first and second magnetic field generating sections are continuously disposed in the circumferential direction of the deposition roller, each magnetic field generating section each include the plurality of magnets for generating the magnetic field that confines the plasma, and the first magnetic field generating section and the second magnetic field generating section may share a portion of magnet.

According to such configuration, it is possible to reduce the installation space of the first magnetic field generating section and the second magnetic field generating section, thereby achieving the compact plasma CVD apparatus.

### INDUSTRIAL APPLICABILITY

As described above, the plasma CVD apparatus according to the present invention is useful for continuously depositing CVD coating on the substrate such as a plastic sheet and suitable for realizing high productivity in the deposition of CVD coating.

The invention is defined by the claims.

## Claims

1. A plasma CVD apparatus, comprising:
a vacuum chamber (4);
a pair of deposition rollers (2) that is disposed in the vacuum chamber (4) and around which, in use, a substrate (W) to be deposited is wound,
said pair of deposition rollers (2) including a first deposition roller and a second deposition roller that is apart from the first deposition roller with an interval such that an axis center thereof is parallel to that of the first deposition roller;
a magnetic field generating section (8, 15) arranged to generate a magnetic field for generating plasma on surfaces of the deposition rollers (2) to form a deposition area (19, 20) where, in use, a coating is deposited on the substrate wound around the deposition rollers,
said magnetic field generating section (8, 15) being disposed such that a first deposition area (19) is formed in a space between the first and the second deposition rollers (2), and such that a second deposition area (20) is formed in a region adjacent to a surface of each deposition roller (2) and other than the space between said first and second deposition rollers (2), as the deposition area,
wherein the magnetic field generating section (8, 15) includes a first magnetic field generating section (8) arranged to generate the plasma in the first deposition area (19) and a second magnetic field generating section (15) arranged to generate the plasma in the second deposition area (20), and
wherein the first magnetic field generating section (8) and the second magnetic field generating section (15) are installed within each deposition roller (2), or
the first magnetic field generating section (8) is installed within each deposition roller (2), and the second magnetic field generating section (15) is installed outside each of the deposition rollers (2) and at a lower side of each deposition roller (2).

2. The plasma CVD apparatus according to claim 1,
wherein the pair of deposition rollers (2) is disposed such that axis centers are directed to a horizontal direction, respectively, and the axis centers are parallel to each other at intervals in the horizontal direction, and
the second deposition area (20) is formed along a portion lower than the space between the first and the second deposition rollers (2) in the surface of each deposition roller (2).

3. The plasma CVD apparatus according to claim 2, wherein:
the plasma CVD apparatus includes a gas supplying section (7) arranged to supply process gas for deposition into the vacuum chamber (4) and a gas exhaust section arranged to exhaust the process gas from the vacuum chamber (4),
the gas supplying section (7) is arranged to supply the process gas into the 20 vacuum chamber (4) from an upper part of the space between the deposition rollers (2), and
the gas exhaust section is arranged to exhaust the process gas to an outside of the vacuum chamber (4) from a lower side of each the deposition roller (2).

4. The plasma CVD apparatus according to claim 1, insofar, as the first magnetic field generating section (8) and the second magnetic field generating section (15) are installed within each deposition roller (2),
wherein the first magnetic field generating section (8) and the second magnetic field generating section (15) each include a plurality of magnets (16, 17, 18) for generating magnetic field that confines the plasma and are disposed at intervals in a circumferential direction of the deposition roller (2), and
a magnetic pole of an outer portion in a radial direction of the deposition roller (2) in a magnet (17) of the second magnetic field generating section-side end of the first magnetic field generating section (8) has the same polarity as that of an outer portion in a radial direction of the deposition roller in a magnet (17) of the first magnetic field generating section-side end of the second magnetic field generating section (15).

5. The plasma CVD apparatus according to claim 1, insofar as the first magnetic field generating section (8) and the second magnetic field generating section (15) are installed within each deposition roller (2),
wherein the first magnetic field generating section (8) and the second magnetic field generating section (15) are continuously disposed in a circumferential direction of the deposition roller (2), and each of the magnetic field generating sections (8, 15) each include a plurality of magnets (16, 17, 18) for generating magnetic field that confines the plasma, and
the first magnetic field generating section (8) and the second magnetic field generating section (15) share a portion of magnet with each other.

## Patentansprüche

1. Plasma-CVD-Gerät mit:
einer Vakuumkammer (4);
einem Paar Abscheidungswalzen (2), das in der Vakuumkammer (4) angeordnet ist, und um welches im Gebrauch ein abzuscheidendes Substrat (W) gewunden ist, wobei das Paar Abscheidungswalzen (2) eine erste Abscheidungswalze und eine zweite Abscheidungswalze aufweist, die von der ersten Abscheidungswalze mit einem solchen Abstand beabstandet ist, dass ihre Achsmitte parallel zu derjenigen der ersten Abscheidungswalze verläuft,
einem Magnetfelderzeugungsabschnitt (8, 15), der so angeordnet ist, dass er ein Magnetfeld zum Erzeugen eines Plasmas an Oberflächen der Abscheidungswalzen (2) erzeugt, um einen Abscheidungsbereich (19, 20) auszubilden, an dem im Gebrauch eine Beschichtung an dem um die Abscheidungswalzen herum gewundenen Substrat abgeschieden wird,
wobei der Magnetfelderzeugungsabschnitt (8, 15) derart angeordnet ist, dass, als der Abscheidungsbereich, ein erster Abscheidungsbereich (19) in einem Raum zwischen der ersten und der zweiten Abscheidungswalze (2) ausgebildet ist, und so, dass ein zweiter Abscheidungsbereich (20) in einer Region ausgebildet ist, die benachbart zu einer Fläche jeder Abscheidungswalze (2) ist und die anders als der Raum zwischen der ersten und der zweiten Abscheidungswalze (2) ist,
wobei der Magnetfelderzeugungsabschnitt (8, 15) einen ersten Magnetfelderzeugungsabschnitt (8), der dazu angeordnet ist, das Plasma in dem ersten Abscheidungsbereich (19) zu erzeugen, und einen zweiten Magnetfelderzeugungsabschnitt (15) aufweist, der dazu angeordnet ist, das Plasma in der zweiten Abscheidungsfläche (20) zu erzeugen, und
wobei der erste Magnetfelderzeugungsabschnitt (8) und der zweite Magnetfelderzeugungsabschnitt (15) innerhalb jeder Abscheidungswalze (2) installiert sind, oder
der erste Magnetfelderzeugungsabschnitt (8) innerhalb jeder Abscheidungswalze (2) installiert ist, und der zweite Magnetfelderzeugungsabschnitt (15) außerhalb jeder der Abscheidungswalzen (2) und an einer unteren Seite jeder Ausscheidungswalze (2) installiert ist.

2. Plasma-CVD-Gerät gemäß Anspruch 1,
wobei das Paar Abscheidungswalzen (2) so angeordnet ist, dass Achsmitten jeweils in einer Horizontalrichtung ausgerichtet sind, und die Achsmitten bei Abständen in der Horizontalrichtung parallel zueinander verlaufen, und
die zweite Abscheidungsfläche (20) entlang eines Abschnitts ausgebildet ist, der tiefer als der Raum zwischen der ersten und der zweiten Abscheidungswalze (2) in der Fläche jeder Abscheidungswalze (2) ist.

3. Plasma-CVD-Gerät gemäß Anspruch 2, wobei
das Plasma-CVD-Gerät einen Gaszuführabschnitt (7) aufweist, der angeordnet ist, um Prozessgas zum Abscheiden in die Vakuumkammer (4) zuzuführen, und einen Gasauslassabschnitt hat, der angeordnet ist, um das Prozessgas von der Vakuumkammer (4) auszulassen,
wobei der Gaszuführabschnitt (7) angeordnet ist, das Prozessgas in die Vakuumkammer (4) von einem oberen Teil des Raums zwischen den Abscheidungswalzen (2) zuzuführen, und
der Gasauslassabschnitt dazu angeordnet ist, das Prozessgas von einer unteren Seite einer jeden Abscheidungswalze (2) zu einer Außenseite der Vakuumkammer (4) auszulassen.

4. Plasma-CVD-Gerät gemäß Anspruch 1, sofern der erste Magnetfelderzeugungsabschnitt (8) und der zweite Magnetfelderzeugungsabschnitt (15) innerhalb jeder Abscheidungswalze (2) installiert sind,
wobei der erste Magnetfelderzeugungsabschnitt (8) und der zweite Magnetfelderzeugungsabschnitt (15) jeweils eine Vielzahl von Magneten (16, 17, 18) zum Erzeugen eines Magnetfelds aufweisen, das das Plasma eindämmt, und bei Abständen in einer Umfangsrichtung der Abscheidungswalze (2) angeordnet sind, und
ein Magnetpol eines äußeren Abschnitts in einer Radialrichtung der Abscheidungswalze (2) in einem Magnet (17) des Endes des ersten Magnetfelderzeugungsabschnitt (8) an der Seite des zweiten Magnetfelderzeugungsabschnitts die gleiche Polarität wie die eines äußeren Abschnitts in einer Radialrichtung der Abscheidungswalze in einem Magnet (17) des Endes des zweiten Magnetfelderzeugungsabschnitts (15) an der Seite des ersten Magnetfelderzeugungsabschnitts hat.

5. Plasma-CVD-Gerät gemäß Anspruch 1, sofern der erste Magnetfelderzeugungsabschnitt (8) und der zweite Magnetfelderzeugungsabschnitt (15) innerhalb jeder Abscheidungswalze (2) installiert sind,
wobei der erste Magnetfelderzeugungsabschnitt (8) und der zweite Magnetfelderzeugungsabschnitt (15) kontinuierlich in einer Umfangsrichtung der Abscheidungswalze (2) angeordnet sind, und jeder der Magnetfelderzeugungsabschnitte (8, 15) jeweils eine Vielzahl von Magneten (16, 17, 18) zum Erzeugen eines Magnetfelds, das das Plasma eindämmt, aufweist, und
der erste Magnetfelderzeugungsabschnitt (8) und der zweite Magnetfelderzeugungsabschnitt (15) den Magnetabschnitt gemeinsam nutzen.

## Revendications

1. Appareil de dépôt chimique en phase vapeur(CVD) assisté par plasma, comprenant :
une chambre à vide (4) ;
une paire de rouleaux de dépôt (2) qui sont disposés dans la chambre à vide (4) et autour desquels, en cours d'utilisation, un substrat (W) à déposer est enroulé,
ladite paire de rouleaux de dépôt (2) comportant un premier rouleau de dépôt et un deuxième rouleau de dépôt qui est espacé du premier rouleau de dépôt avec un intervalle de sorte qu'un centre d'axe de celui-ci soit parallèle à celui du premier rouleau de dépôt ;
une section de génération de champ magnétique (8, 15) agencée pour générer un champ magnétique afin de générer un plasma sur les surfaces des rouleaux de dépôt (2) pour former une zone de dépôt (19, 20) où, en cours d'utilisation, un revêtement est déposé sur le substrat enroulé autour des rouleaux de dépôt,
ladite section de génération de champ magnétique (8, 15) étant disposée de sorte qu'une première zone de dépôt (19) soit formée dans un espace entre les premier et deuxième rouleaux de dépôt (2), et de sorte qu'une deuxième zone de dépôt (20) soit formée dans une région adjacente à une surface de chaque rouleau de dépôt (2) et autre que l'espace entre lesdits premier et deuxième rouleaux de dépôt (2), comme étant la zone de dépôt,
dans lequel la section de génération de champ magnétique (8, 15) comporte une première section de génération de champ magnétique (8) agencée pour générer le plasma dans la première zone de dépôt (19) et une deuxième section de génération de champ magnétique (15) agencée pour générer le plasma dans la deuxième zone de dépôt (20), et
dans lequel la première section de génération de champ magnétique (8) et la deuxième section de génération de champ magnétique (15) sont installées dans chaque rouleau de dépôt (2), ou
la première section de génération de champ magnétique (8) est installée dans chaque rouleau de dépôt (2), et la deuxième section de génération de champ magnétique (15) est installée à l'extérieur de chacun des rouleaux de dépôt (2) et au niveau d'un côté inférieur de chaque rouleau de dépôt (2).

2. Appareil (CVD) assisté par plasma selon la revendication 1,
dans lequel la paire de rouleaux de dépôt (2) sont disposés de sorte que des centres d'axe soient dirigés vers une direction horizontale, respectivement, et les centres d'axe sont parallèles les uns aux autres à des intervalles dans la direction horizontale, et
la deuxième zone de dépôt (20) est formée le long d'une partie inférieure à l'espace entre les premier et deuxième rouleaux de dépôt (2) dans la surface de chaque rouleau de dépôt (2).

3. Appareil (CVD) assisté par plasma selon la revendication 2, dans lequel :
l'appareil (CVD) assisté par plasma comporte une section d'alimentation en gaz (7) agencée pour fournir un gaz de procédé pour le dépôt dans la chambre à vide (4) et une section d'échappement de gaz agencée pour évacuer le gaz de procédé de la chambre à vide (4),
la section d'alimentation en gaz (7) est agencée pour fournir le gaz de procédé dans la chambre à vide (4) à partir d'une partie supérieure de l'espace entre les rouleaux de dépôt (2), et
la section d'échappement de gaz agencée pour évacuer le gaz de procédé vers l'extérieur de la chambre à vide (4) à partir d'un côté inférieur de chacun des rouleaux de dépôt (2).

4. Appareil (CVD) assisté par plasma selon la revendication 1, dans la mesure où la première section de génération de champ magnétique (8) et la deuxième section de génération de champ magnétique (15) sont installées dans chaque rouleau de dépôt (2),
dans lequel la première section de génération de champ magnétique (8) et la deuxième section de génération de champ magnétique (15) comportent chacune une pluralité d'aimants (16, 17, 18) pour générer un champ magnétique qui confine le plasma et sont disposées à des intervalles dans une direction circonférentielle du rouleau de dépôt (2), et
un pôle magnétique d'une partie extérieure dans une direction radiale du rouleau de dépôt (2) dans un aimant (17) de l'extrémité côté deuxième section de génération de champ magnétique de la première section de génération de champ magnétique (8) a la même polarité que celle d'une partie extérieure dans une direction radiale du rouleau de dépôt dans un aimant (17) de l'extrémité côté première section de génération de champ magnétique de la deuxième section de génération de champ magnétique (15).

5. Appareil (CVD) assisté par plasma selon la revendication 1, dans la mesure où la première section de génération de champ magnétique (8) et la deuxième section de génération de champ magnétique (15) sont installées dans chaque rouleau de dépôt (2),
dans lequel la première section de génération de champ magnétique (8) et la deuxième section de génération de champ magnétique (15) sont disposées en continu dans une direction circonférentielle du rouleau de dépôt (2), et chacune des sections de génération de champ magnétique (8, 15) comporte une pluralité d'aimants (16, 17, 18) pour générer un champ magnétique qui confine le plasma, et
la première section de génération de champ magnétique (8) et la deuxième section de génération de champ magnétique (15) partagent une partie d'aimant l'une avec l'autre.
